# EUROPEAN PATENT APPLICATION

(11) **EP 0 549 545 A2**
(43) Date of publication of application: **30.06.1993**
(21) Application number: 92830663.8
(22) Date of filing: 10.12.1992
(51) Int. Cl.: H01J 37/32, C23C 14/32

(54) **Electric arc evaporator**

(30) Priority: 13.12.1991 IT BS910135
(71) Applicant: UNICOAT S.r.l., I-24060 Pianico, Bergamo (IT)
(72) Inventor: Belletti, Manuela, I-24060 Pianico, Bergamo (IT)
(74) Representative: Manzoni, Alessandro

(57) **Abstract**

This invention concerning an electric arc evaporator including an anode (3), a support and a cathode system with a plurality of cathodes (1) to be evaporated, an electric conductor (4) and a screen (5) surrounding the periphery of the cathode. This electric arc vaporizer cathode system containes many cathodes placed in a chess-board pattern, into the common screen openings, each cathode having an electric conductor connected to a independent feeding source and a magnetic screen.

## Description

### FIELD OF THE TECHNIC

This invention can be classified as a formation of covering obtained in absolute vacuum caused by metallic plasma condensation, coming from an electrode surface, in the presence of a voltaic arc.

### STATE OF THE ART

The metal evaporation in the voltaic arc condition with a certain difference from other methods for the formation of a condition of absolute vacuum metallic coverings , allows to obtain a strong covering adherence to the base (that is possible to compare to the endurance against the breakage of the base material itself) using materials having high hardness (alloy having high fusion point, such as carbides, oxides, intrides, etc.).

Using this methods, the metallic plasma layed down on the piece to cover, comes from the cathode surface and only from the part of the cathodal spot where the electric arc is ; the cathodal spot moves in a casual manner on to the cathode surface to evaporate. The cathodal spot must be stable on the cathode working surface and in this way the evaporator works correctly.

There are electric arc vaporizers that use several methods to obtain the cathodal spot steadiness.

The most recent vaporizer is described in US-A- 4512867.

In this vaporizer, the cathode ( material for evaporation ), has a disk form. The body determing the absolute vacuum chamber is used as anode. The pieces to cover are placed in front of the cathode on a special support that is insulated from the anode. The cathode is placed, in a glass of non-magnetic material, around which an electro-magnetical coil is wrapped up. The coil placed in such a manner the force lines of its magnetic field are inclined as regards the cathode working surface. Along the external surface , the electro-magnetical coil is surrounded by the magnetic circuit, so that the magnetic field in-influence is reinforced on the cathodal spot displacement, along the cathode head.

The already known devices give high quality coverings only there is a minimum discharge current and so they have , of course, a low evaporation yield. It is not possible to increase the yield by increasing the current in the arc.

The current increase goes with the presence of a great amount and quantity of micro particles ( this is called drops phase ) in the metallic plasma flux. That drives to an essential and not admissible lowering of the coverings quality.

Likewise, for the plasma current increase ,it is not possible to put near several vaporizers because the vaporizers magnetic fields placed in line negatively influenced the uniformity of the cathode wear and tear and the "discharge" stability. Moreover , the increase of the cathode dimension, doesn't increase the vaporizer yield. The evaporation intensity dipends only on the current entity of the discharge in the arc condition. There can be several vaporizers in only one device. The distance among the vaporizers must never be lower than the distance between the cathode and the piece to treat. Also in systems with many vaporizers , because the vaporizators are near one to the other, it is not possible to increase the deposit intensity of the material on the surface to cover.

The pubblication USSR-368807 , describes a several cathodes electric arc vaporizer having magnetic stabilization of the cathodal spot. The vaporizer is composed of cathodes which are totally feeded, having frustum-conic form , placed inside a general solenoid and inside the general magnetic screen, which at the solenoid side, surrounds part of the lateral surface of the cathodes.

The presence of the general solenoid and the presence of the magnetic screen, don't allow to create regular focal fields around the cathodes , so , only no more than three or four cathodes can be joined together at the same time, and moreover for a regular vaporization it is necessary that the cathodes run around the axis during the working phase and it is necessary the current is somewhat high to keep stable the arc ( 120A for the titanium ).

Such a construction allows to increase the yield , but the problem to form the drops phase is still not solved.

### INVENTION NOVELTY

The invention object is to increase the vaporization yield without having a drop phase in an electric arc vaporizer.

For this reason , the vaporizer is realized using many cathodes individually feeded in high selfstabilization con dition of the cathodical spot. The vaporizer also has a general screen with openings in wich the cathodes are placed.

In order that the external magnetic fields of the various cathodes do not give troubles to each other and , to avoid having distorsions in the magnetic field , ( because , it creates the cathodal spot movement ) the current conductor and the cathode , are surrounded by magnetic material having high permeability.

To avoid the evaporated material from a cathode falls onto the next cathode , between the cathodes and the support an additional cellular anode is placed and it is electrically joined to the main anode.

The cell walls are placed inside the interstice among the cathodes. To avoid wrong passings of the arc on the evaporizer structure , during the evaporization phase, specially for seldom evaporable materials, the general screen and the magnetic screens are joined together to the anode through a condenser.

During the cathodal spot movement onto the lateral surface of the cathode or onto the current conductor the condensers charging themselves and the screens have the potential from the cathode. The current between the cathode and the screens breaks off , and the cathodal spot disappears and reaches the selfstabilization in this way. An example of the invention practical realization is shown through the following drawings and disclosed only in an indicative and not restrictive none. in said drawings:

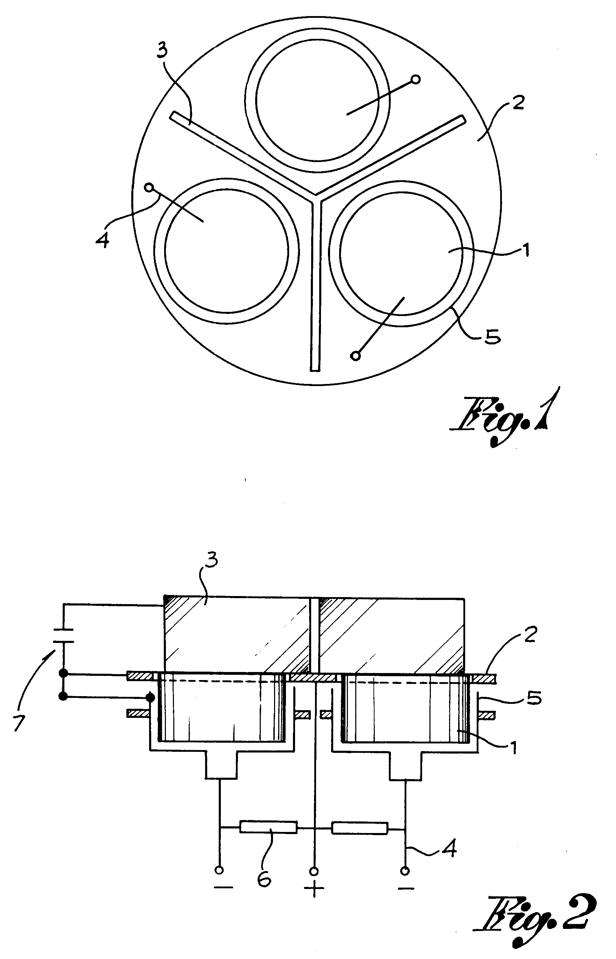

- Figure 1 and Figure 2 show plan and section views of the three cathodes electric arc evaporizer Figure 1 shows three cathodes 1 included in a screen plate 2 and divided by the anodes 3. Each cathode is provided with an electrod 4 and is protected by magnetic screen protection 5. The electric arc evaporizer works as follows.
The vacuum goes down into the chamber starting for instance from a 1,33x10-1 to, for instance, a 6,65x10-3 Pa ,final pressure. Between the anode 3 and the cathode 1 is created a difference about 60V of potential. The priming electrode 4 , also joined to the anode through an equilibrium resistor 6 , is connected to the cathode and there is a discharge in arc condition. In case of titanium, for instance the voltaic arc is formed at an electric current of 60-70 Amperes, Having these current values , the evaporation intensity is moderate, but the obtained coverings quality is very good , because in this way the macroparticles ( drops ) projection reduces.

The current intensity needed for a high production of evaporated material is obtained using cathodes very closed one to the other. To avoid the falling of the evaporated particles from a cathode to another , the above mentioned anode 3 , having cell form, is placed between , the two cathodes . This multiple system, system using several cathodes , can be used to change the application speed of the coverings , for instance , to obtain coverings having a different thickness on the different sides of the piece to cover.

### EXAMPLE OF REALIZATION

A multiple system has been realized using 14 cathodes. These titanium cathodes have circular section and have 80 mm diameter and 15 mm thickness.

The voltaic arc is generated from electrodes which are connected to the anode through resistors and controlled by electromagnets. The screen 2 is joined to the anode by a condenser 7 having a 20µF capacity. The cells made of anode 3 had a suitable height.

The cathodes having magnetic circuits have been protected by magnetic steel screens of 4 mm thickness and connected to the anode through the condenser 7. The current of a cathode was 60 A. Using this system , a velocity of evaporation , twice or three times greater is obtained , as regards the single vaporizers using the same value for the discharge. Consequentely, the coverings quality also has improved. During the use , the vaporizer didn't need any adjustment. Some titanium cathodes have been changed with some columbium cathodes , so that in this way a covering containing two elements is obtained.

## Claims

1. A voltaic arc vaporizer comprising an anode, a support for a cathodal system having several cathodes (1) to evaporate ,an electric conductor and a screen regarding the lateral surface of the cathodal system, vaporizer characterized in that the chatodal system contains a plurality of cathodes (1) on the common screen (2) openings, said cathodes being placed in a chess-board mode and each having an electric conductor (4) connected to a autonomous feeding source.

2. Voltaic ar vaporizer comprising an anode, a suport for a cathodal system having a plurality of cathodes (1) to evaporate, an electric conductor and a screen regarding the lateral surface of the cathodal system, vaporizer characterized in that the cathodal system in the common screen openings (2), contains a plurality of cathodes (1) in a chess-board and each of them provided with a magnetic screen (5) surronding the lateral surface.

3. Voltaic arc vaporizer comprising a main anode, a support for a cathodal system having a plurality of cathodes (1) to evaporate, an electric conductor and a screen concerning the lateral surface of the catodal system, vaporizer characterized in that the cathodal system comprise a plurality of cathodes placed in common screen openings in a chess-board mode in such a way that each cathode is individually surrounded on its lateral surface into a magnetic screen and each cathode is separately feeded from all tile other cathodes.

4. A voltaic arc vaporizer accrding to one of the claims 1 to 3, in which among the cathodes is placed and additional anode (3) forming cells surrounding each cathode, said additional anode (3) being electrically connected to the main anode, the height of the additional anode, being not less than the half cathode diameter.
